# EUROPEAN PATENT APPLICATION

(11) **EP 4 637 302 A1**
(43) Date of publication of application: **22.10.2025**
(21) Application number: 25159022.0
(22) Date of filing: 20.02.2025
(51) Int. Cl.: H10F 71/00

(54) **TRANSPORT DEVICE AND TABBING APPARATUS INCLUDING THE SAME**

(30) Priority: 22.02.2024 KR 20240025910
(71) Applicant: Hanwha Solutions Corporation, Jung-gu Seoul 04541 (KR)
(72) Inventor: JUNG, Min Kyo, 04541 Seoul (KR); BAEK, Dong Heon, 04541 Seoul (KR); CHUNG, Dong Jin, 04541 Seoul (KR)
(74) Representative: Mooser, Sebastian Thomas

(57) **Abstract**

The present disclosure relates to a transport device and a tabbing apparatus including the same, and the transport device includes a transport main body, a position adjustment unit configured to support the transport main body and adjust a position of the transport main body, and a transport unit configured to move along with the transport main body and transport a wire and a jig.

## Description

### BACKGROUND

### 1. Field of the Invention

The present disclosure relates to a transport device and a tabbing apparatus including the same, and more specifically, to a transport device and a tabbing apparatus including the same, which allow a wire and a jig to be transported at the same time.

### 2. Discussion of Related Art

In general, a solar cell is formed by arranging p-n junction diodes on a substrate. When a solar cell is irradiated with sunlight, an exciton, which is an electron-hole pair, is generated, and as the exciton separates, the electron moves to an n layer, the hole moves to a p layer, and thus photovoltaic power is generated at a p-n junction.

In general, since the maximum voltage generated by a single unit solar cell is only about 0.5 V, multiple solar cells need to be connected in series to be used. A module formed by connecting multiple unit solar cells in this way is called a solar cell module.

A tabbing process is a process of forming a single solar cell module by arranging wires on a plurality of solar cells and electrically connecting the plurality of solar cells.

The background technology of the present disclosure is disclosed in Korean Patent Registration No. 10-1058399 (registered on August 16, 2011, entitled "Tabber-stringer and tabbing-stringing method).

### SUMMARY OF THE INVENTION

The present disclosure is directed to providing a transport device and a tabbing apparatus including the same, which allow a wire and a jig to be transported at the same time.

According to an aspect of the present disclosure, there is provided a transport device including a transport main body, a position adjustment unit configured to support the transport main body and adjust a position of the transport main body, and a transport unit configured to move along with the transport main body and transport a wire and a jig.

The position adjustment unit may include a first position adjustment unit connected to the transport main body and configured to move the transport main body in a direction parallel to a first direction and a second position adjustment unit connected to the first position adjustment unit and configured to move the transport main body in a direction intersecting the first direction.

The transport main body may be connected to the position adjustment unit to be movable in a direction parallel to a longitudinal direction of the wire.

The transport unit may include a first transport member connected to the transport main body and configured to transport the wire and a second transport member spaced apart from the first transport member and configured to transport the jig.

The first transport member may include a gripper connected to the transport main body and configured to grip the wire and a gripper driving unit connected to the gripper and configured to adjust the gripping operation of the gripper.

The jig may include a through hole, and as the transport main body moves toward the wire, the gripper may be inserted into the through hole and may protrude outward from the jig.

The gripper may be provided as a plurality of grippers, and the plurality of grippers may be arranged in a longitudinal direction of the wire.

The gripper may include a first gripper rotatably connected to the transport main body, a second gripper disposed to face the first gripper and rotatably connected to the transport main body, a first extension extending from the first gripper, and a second extension extending from the second gripper and disposed to face the first extension, and the first extension and the second extension may rotate in opposite directions and adjust a distance between the first gripper and the second gripper.

The gripper driving unit may include an actuator configured to generate a driving force and an adjustment member configured to rotate the first extension and the second extension in opposite directions in conjunction with the driving force generated by the actuator.

The adjustment member may include an adjustment block which is installed to be movable on the transport main body and receives the driving force from the actuator to move, an adjustment groove which is disposed inside the adjustment block and into which the first extension and the second extension are inserted, and a restoring member disposed between the first extension and the second extension.

A width of the adjustment groove may increase from the adjustment block toward the gripper.

The restoring member may be provided to be elastically deformable.

The second transport member may include a first jig holder disposed to face one side of the first transport member and a second jig holder spaced apart from the first jig holder and disposed to face the other side of the first transport member.

The first jig holder and the second jig holder may generate an electromagnetic force to adsorb the jig.

The first jig holder and the second jig holder may be spaced apart from each other in a direction intersecting a longitudinal direction of the wire.

A tabbing apparatus according to the present disclosure includes a supply device configured to supply a solar cell, a wire, and a jig, a transport device configured to seat the wire and the jig on the solar cell, and a bonding device configured to bond the solar cell and the wire, wherein the transport device includes a transport main body, a position adjustment unit configured to support the transport main body and adjust a position of the transport main body, and a transport unit configured to move along with the transport main body and transport the wire and the jig.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a schematic plan view illustrating a configuration of a tabbing apparatus according to one embodiment of the present disclosure;
FIG. 2 is a schematic front view illustrating the configuration of the tabbing apparatus according to one embodiment of the present disclosure;
FIG. 3 is a schematic perspective view illustrating a configuration of a transport device according to one embodiment of the present disclosure;
FIG. 4 is a schematic side view illustrating the configuration of the transport device according to one embodiment of the present disclosure;
FIG. 5 is a schematic front view illustrating the configuration of the transport device according to one embodiment of the present disclosure;
FIG. 6 is a schematic perspective view illustrating a configuration of a transport unit according to one embodiment of the present disclosure;
FIG. 7 is a schematic front view illustrating the configuration of the transport unit according to one embodiment of the present disclosure;
FIG. 8 is a schematic side view illustrating the configuration of the transport unit according to one embodiment of the present disclosure;
FIG. 9 is a schematic view illustrating a configuration of a gripper according to one embodiment of the present disclosure; and
FIGS. 10 to 15 are schematic views illustrating an operation process of the transport device according to one embodiment of the present disclosure.

### DETAILED DESCRIPTION OF EXEMPLARY EMBODIMENTS

Hereinafter, embodiments of the present disclosure will be described, in detail, with reference to the accompanying drawings. Prior to this, terms or words used in this specification and claims should not be interpreted as limited to their usual or dictionary meanings and should be interpreted as meanings and concepts that conform to the technical idea of the present disclosure based on the principle that the inventor can appropriately define the concepts of the terms in order to describe his or her own invention in the best way. The embodiments described in this specification and the configurations shown in the drawings are only some embodiments of the present disclosure and do not represent all of the technical ideas of the present disclosure. Accordingly, it should be understood that there may be various equivalents and modifications that can replace them at the time of filing this application. In addition, when used in the present specification, "comprise" and "include" and/or "comprising" and "including" specify the presence of the stated features, numbers, steps, operations, members, elements, and/or groups thereof and do not preclude the presence or addition of one or more other features, numbers, operations, members, elements, and/or groups thereof. In addition, when describing embodiments of the present disclosure, "may" and "may be" may include "one or more embodiments of the present disclosure."

In addition, to facilitate understanding of the invention, the accompanying drawings are not drawn to scale, and the dimensions of some components may be shown in an exaggerated manner. In addition, the same reference numbers may denote the same components in different embodiments.

When two objects of comparison are "the same", it means that they are "substantially the same." Accordingly, "substantially the same" may include a deviation that is considered low in the art, for example, a deviation within 5%. In addition, uniformity of a parameter over a given region may mean uniformity from the viewpoint of an average.

Although "first," "second," etc. are used to describe various components, these components are not limited by these terms. These terms are used only to distinguish one component from another, and unless otherwise stated, it is obvious that a first component may be a second component.

Throughout the specification, unless otherwise stated, each element may be singular or plural.

When any component is disposed "above (or below)" or "on (or under)" a component, it may mean not only that any component is disposed in contact with an upper surface (or lower surface) of the component, but also that other components may be interposed between the component and any component disposed on (or under) the component.

In addition, when a certain component is described as being "connected," "coupled," or "joined" to another component, the components may be directly connected or joined, but it should be understood that another component may be "interposed" between the components, or the components may be "connected," "coupled," or "joined" through the other component. In addition, when a first component is described as being "electrically coupled to" a second component, this includes not only a case in which the first component is "directly coupled" to the second component, but also a case in which the first component is "coupled" to the second component with a third component interposed therebetween.

When referring to "A and/or B" throughout the specification, this means A, B or A and B unless otherwise specified. In other words, the term "and/or" includes all or any combination of the plurality of listed items. When referring to "C to D," this means C or more and D or less unless otherwise specified.

When phrases such as "at least one of A, B, and C, "at least one of A, B, or C," "at least one selected from a group of A, B, and C," and "at least one selected from among A, B, and C" are used to designate a list of elements A, B, and C, the phrase may refer to any and all suitable combinations thereof.

The term "use" may be considered synonymous with the term "utilize." As used herein, the terms "substantially," "about," and similar terms are used as terms of approximation and not as terms of degree and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be named a second element, component, region, layer, or section without departing from the teachings of example embodiments.

Spatially relative terms, such as "beneath," "below," "lower," "above," "upper," and the like, may be used herein for ease of description to describe a relationship of one element or feature to (an)other element(s) or feature(s) as illustrated in the drawings. It will be understood that the spatially relative terms are intended to encompass different orientations of the device in use or operation in addition to the orientations depicted in the drawings. For example, if a device in the drawings is turned over, elements described as "below" or "beneath" other elements would then be oriented "above" or "over" the other elements. Thus, the term "below" may encompass both an orientation of above and below.

The terminology used herein is intended to describe embodiments of the present disclosure and is not intended to limit the present disclosure.

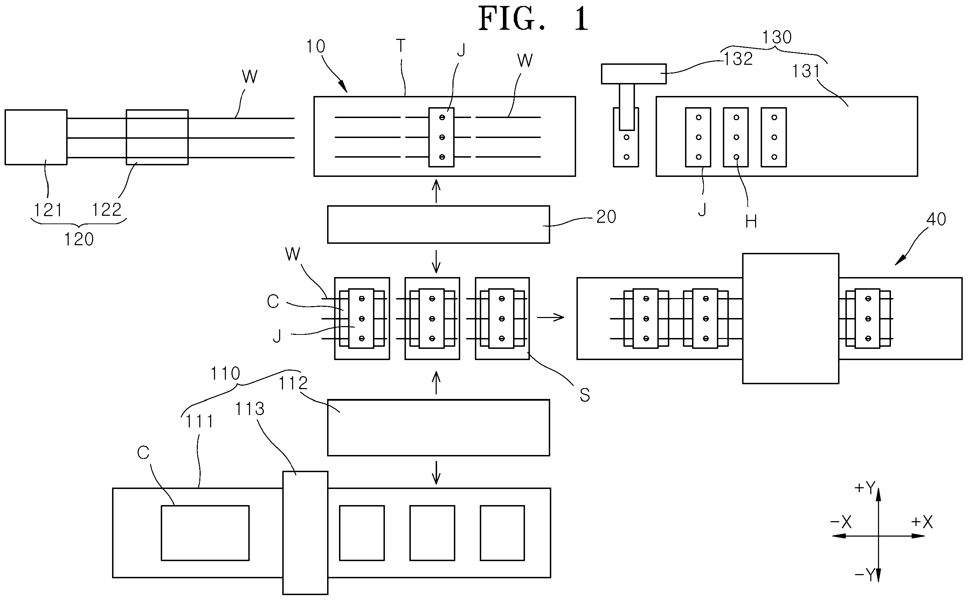

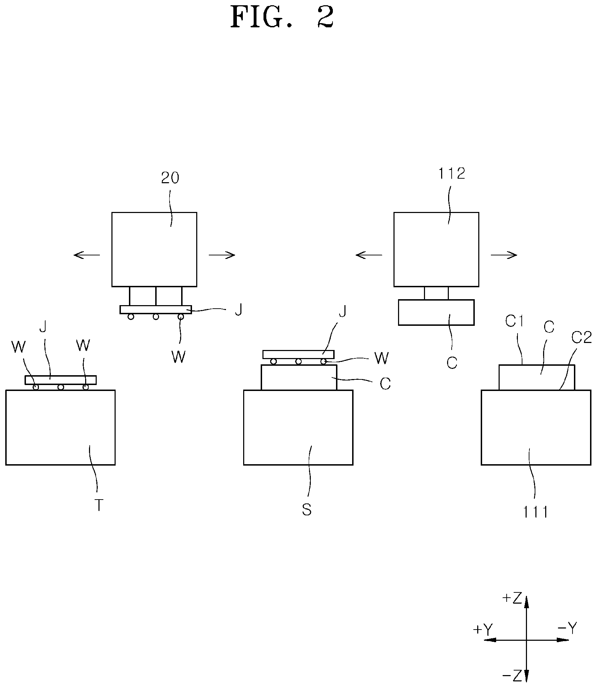

FIG. 1 is a schematic plan view illustrating a configuration of a tabbing apparatus according to one embodiment of the present disclosure, and FIG. 2 is a schematic front view illustrating the configuration of the tabbing apparatus according to one embodiment of the present disclosure.

As will be described below, a first direction may be a -Z-axis direction based on FIG. 2, a second direction may be a direction parallel to a -X-axis direction based on FIG. 1, and a third direction may be a +Y-axis direction based on FIG. 1.

A tabbing apparatus is an apparatus for connecting solar cells C to wires W to form a solar cell module.

Referring to FIGS. 1 and 2, the tabbing apparatus according to the present embodiment includes a supply device 10, a transport device 20, and a bonding device 40.

The supply device 10 may include a cell supply device 110, a wire supply device 120, and a jig supply device 130.

The cell supply device 110 may supply the solar cell C.

The solar cell C has a semiconductor junction area having a p-n junction surface, and when energy with a predetermined magnitude or more is radiated, an electromotive force may be generated to convert light energy into electrical energy. A material of a semiconductor included in the solar cell C is not particularly limited, and silicon (single crystalline, polycrystalline, or amorphous silicon), gallium arsenide, cadmium tellurium, cadmium sulfide, indium phosphide, copper indium gallium selenide (CIGS), an organic dye, or a mixture thereof may be used.

The solar cell C may include a first surface C1 and a second surface C2 that are opposite to each other. The first surface C1 and the second surface C2 may serve as a positive electrode and a negative electrode of the solar cell C, respectively. The first surface C1 and the second surface C2 may be disposed to be spaced apart from each other in the first direction.

The cell supply device 110 may include a cell supply line 111 and a cell transport unit 112.

The cell supply line 111 may consecutively supply a plurality of solar cells C. For example, the cell supply line 111 may include various types of supply units, such as a belt conveyor, a chain conveyor, a roller conveyor, a shuttle conveyor, and the like, which can consecutively supply the plurality of solar cells C in one direction.

The cell transport unit 112 may move the solar cell C supplied from the cell supply line 111 to a stage S spaced apart from the cell supply line 111. The cell transport unit 112 may move in a reciprocating or circulating manner between the cell supply line 111 and the stage S and transport the solar cell C supplied from the cell supply line 111 to the stage S. The cell transport unit 112 may include an adsorption means for adsorbing the solar cell C by vacuum pressure, a gripping means for mechanically gripping the solar cell C, or the like. The solar cell C may be seated on the stage S so that the second surface 2 faces the stage S.

The cell transport unit 112 may simultaneously move a plurality of solar cells C to the stages S. The number of solar cells C transported by the cell transport unit 112 may be designed to vary. In this case, a plurality of stages S may be arranged in the second direction, and each solar cell C may be individually seated on a different stage S.

The cell supply device 110 may further include a cell splitting unit 113.

The cell splitting unit 113 may be connected to the cell supply line 111. The cell splitting unit 113 may split the solar cell C supplied by the cell supply line 111 into a size set according to a required size. For example, the cell splitting unit 113 may bisect the solar cell C supplied by the cell supply line 111. The cell splitting unit 113 may include various types of cutting means such as a laser, a water jet, a blade, or the like. The solar cell C moving in one direction from a front end side of the cell supply line 111 may be split by the cell splitting unit 113 and then moved toward a rear end of the cell supply line 111. Thereafter, the solar cell C moved to the rear end side of the cell supply line 111 may be transported to the stage S by the cell transport unit 112.

FIG. 1 illustrates an example in which the cell supply device 110 includes the cell splitting unit 113, but the cell supply device 110 is not limited thereto and may not include the cell splitting unit 113.

The wire supply device 120 may supply a wire W.

The wire W may serve as a conductor for electrically connecting a plurality of solar cells C. The wire W may electrically connect a pair of solar cells C disposed adjacent to each other in a solar cell module. For example, both sides of the wire W may be connected to the first surface C1 of one of the neighboring solar cells C and the second surface C2 of the other, respectively.

The wire W may be electrically connected to the solar cell C through a soldering process. Alternatively, the wire W may be electrically connected to the solar cell C through an electrically conductive adhesive (ECA) curing process.

The wire supply device 120 according to the present embodiment may include a wire supply line 121 and a wire cutting unit 122.

The wire supply line 121 may supply the wire W to the wire cutting unit 122 to be described below. For example, the wire supply line 121 may include various types of supply units for drawing out the wire W wound around a roller (not illustrated) and transporting the wire W to the wire cutting unit 122.

The wire supply line 121 may supply a plurality of wires W in parallel. For example, the wire supply line 121 may supply the wire W so that the plurality of wires W are arranged at set intervals in a direction perpendicular to a longitudinal direction of one wire W.

The wire cutting unit 122 may cut the wire W supplied from the wire supply line 121. The wire cutting unit 122 may cut the wire W supplied from the wire supply line 121 into a unit length. The unit length of the wire W cut by the wire cutting unit 122 may be greater than the length of one solar cell C and smaller than the total length of a pair of solar cells C. Here, the length of the solar cell C may be a length parallel to the second direction.

The wire cutting unit 122 may cut one wire W supplied from the wire supply line 121 into wires of the same number as the number of solar cells C seated on the stage S.

The wire cutting unit 122 may simultaneously cut the plurality of wires W supplied in parallel by the wire supply line 121.

The wire W cut by the wire cutting unit 122 may be transported to a wire-jig table T.

The wire-jig table T according to the present embodiment may be disposed to face the cell supply line 111 with the stage S interposed therebetween. For example, the cell supply line 111, the stage S, and the wire-jig table T may be disposed sequentially in the third direction.

The wire W cut by the wire cutting unit 122 may be transported to the wire-jig table T by a separate transport means such as a conveyor, an adsorber, or the like and transported to the wire-jig table T by the independent movement of the wire-jig table T, the wire supply line 121, and the wire cutting unit 122.

The plurality of wires W may be arranged in a direction parallel to the second direction on the wire-jig table T. The number of wires W arranged in the direction parallel to the second direction on the wire-jig table T may be equal to the number of solar cells C seated on the stage S. When the wire supply line 121 supplies the wire W in parallel, the plurality of wires W may be arranged in the direction parallel to the second direction and the third direction on the wire-jig table T. The number of wires W arranged in a direction parallel to the third direction on the wire-jig table T may be designed to vary depending on the width or the like of the solar cell C parallel to the third direction.

When the solar cell C and the wire W are bonded through a soldering process, the wire supply device 120 may further include a flux application device (not illustrated) for applying a flux on a surface of the wire W.

When the solar cell C and the wire W are bonded through an ECA curing process, the cell supply device 110 may further include an ECA application device (not illustrated) for applying an ECA on the first surface C1 and the second surface C2 of the solar cell C.

The jig supply device 130 may supply a jig J.

The jig J may serve as a component for fixing the wire W to prevent the wire W from being lifted or separated from a specified position when the solar cell C and the wire W are bonded by the bonding device 40 to be described below. The jig J may have a plurality of through holes H formed to vertically pass through both surfaces of the jig J.

The jig supply device 130 may include a jig supply line 131 and a jig transport unit 132.

The jig supply line 131 may consecutively supply a plurality of jigs J. For example, the jig supply line 131 may include various types of supply units, such as a belt conveyor, a chain conveyor, a roller conveyor, a shuttle conveyor, and the like, which can consecutively supply the plurality of jigs J in one direction. The jig supply line 131 may recover and supply the jig J discharged from the bonding device 50.

The jig transport unit 132 may transport the jig J supplied from the jig supply line 131 to the wire-jig table T. For example, the jig transport unit 132 may be installed to reciprocate between the jig supply line 131 and the wire-jig table T. The jig transport unit 132 may include an adsorption means for adsorbing the jig J by vacuum pressure, a gripping means for mechanically gripping the jig J, or the like. The jig transport unit 132 may seat the jig J on the wire W disposed on the wire-jig table T. As the jig J is seated on the wire W, the through hole H formed in the jig J may be disposed to face the wire W.

The transport device 20 may seat the wire W and the jig J on the solar cell C. That is, the transport device 20 may serve as a component for simultaneously moving the wire W and the jig J which are seated on the wire-jig table T onto the first surface C1 of the solar cell C seated on the stage S. Accordingly, the transport device 20 can shorten the overall process time and reduce the size of the equipment compared to a case in which the wire W and the jig J are transported by separate devices.

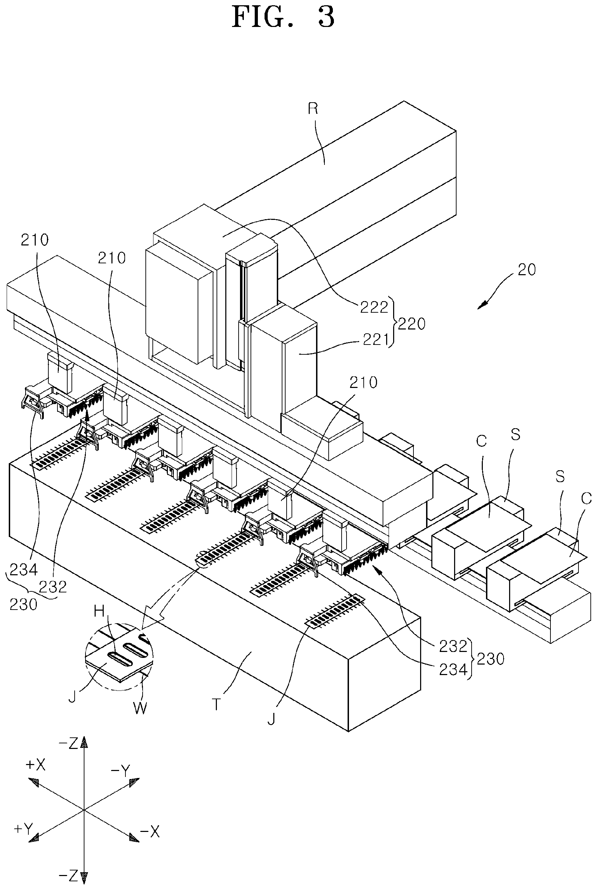

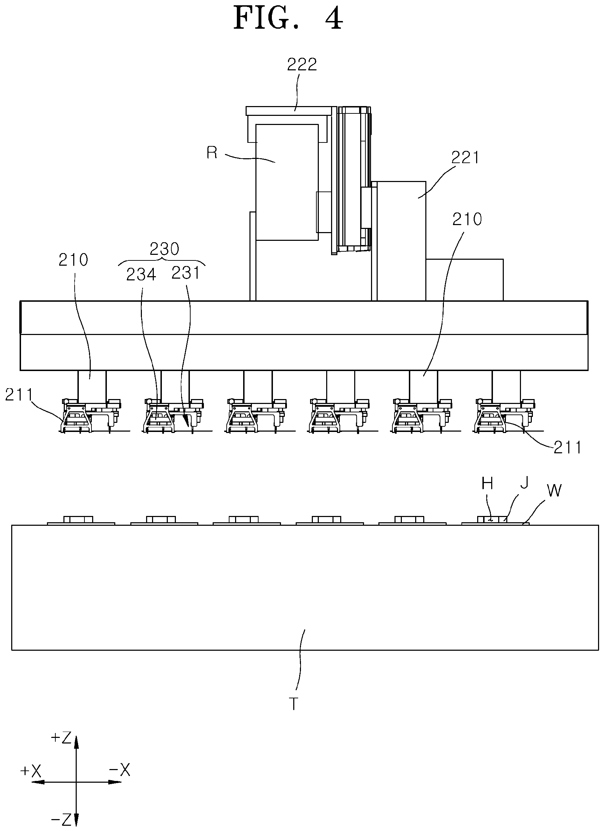

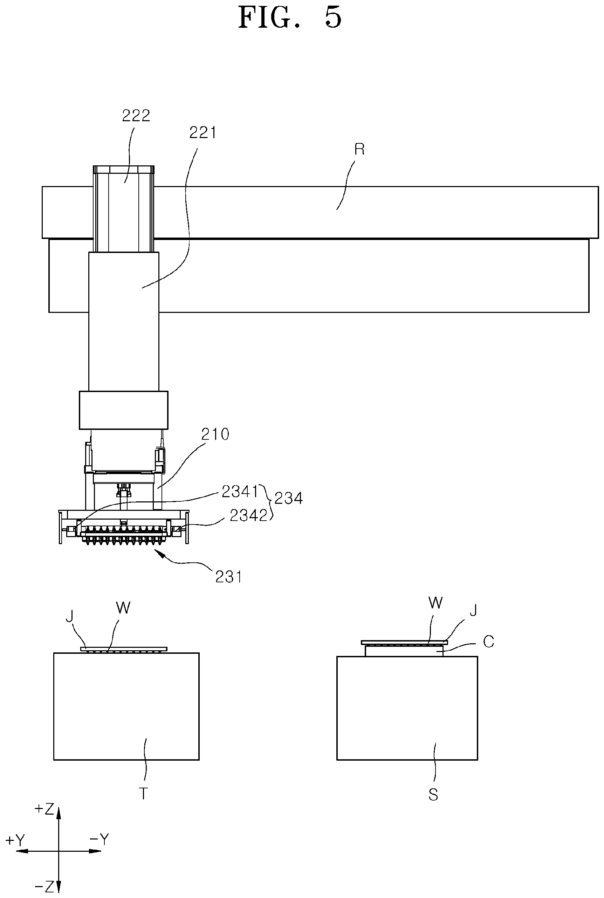

FIG. 3 is a schematic perspective view illustrating a configuration of a transport device according to one embodiment of the present disclosure, FIG. 4 is a schematic side view illustrating the configuration of the transport device according to one embodiment of the present disclosure, and FIG. 5 is a schematic front view illustrating the configuration of the transport device according to one embodiment of the present disclosure.

Referring to FIGS. 3 to 5, the transport device 20 according to the present embodiment may include a transport main body 210, a position adjustment unit 220, and a transport unit 230.

The transport main body 210 may be installed to be movable to a position above the first surface C1 of the solar cell C. More specifically, a position of the transport main body 210 may be freely changed in a space above the first surface C1 of the solar cell C by the position adjustment unit 220 to be described below. A specific shape of the transport main body 210 is not limited to the shape illustrated in FIGS. 3 to 5 and may be designed to have various shapes which can be connected to the position adjustment unit 220 to support the transport unit 230.

A support frame 211 may be formed on the transport main body 210. The support frame 211 may serve as a component which comes into contact with the wire-jig table T or the stage S to support the transport main body 210 when the transport main body 210 moves toward the wire-jig table T or the stage S.

The support frame 211 according to the present embodiment may be provided as a pair of support frames. The pair of support frames 211 may be disposed symmetrically at both sides of the transport main body 210. For example, the pair of support frames 211 may be disposed to be spaced apart from each other in the third direction with the transport main body 210 interposed therebetween. A specific shape of the support frame 211 is not limited to the shape illustrated in FIGS. 3 to 5, and various design changes are possible within the technical concept of the shape which can come into contact with the wire-jig table T or the stage S when the transport main body 210 moves toward the wire-jig table T or the stage S.

The position adjustment unit 220 may support the transport main body 210 and adjust the position of the transport main body 210. The position adjustment unit 220 may be provided to adjust the position of the transport main body 210 in multiple directions.

The position adjustment unit 220 may include a first position adjustment unit 221 and a second position adjustment unit 222.

The first position adjustment unit 221 may be connected to the transport main body 210 and may move the transport main body 210 in a direction parallel to the first direction. That is, the first position adjustment unit 221 may serve as a component for increasing or decreasing a vertical distance between the transport main body 210 and the solar cell C.

The first position adjustment unit 221 according to the present embodiment may reciprocate in the direction parallel to the first direction by a driving force generated from a motor, a cylinder, or the like. A specific shape of the first position adjustment unit 221 is not limited to the shape illustrated in FIGS. 3 to 5 and various design changes are possible within the technical concept of the shape which can be connected to the transport main body 210 to move the transport main body 210 in the direction parallel to the first direction.

The second position adjustment unit 222 may be connected to the first position adjustment unit 221 to move the transport main body 210 in a direction intersecting the first direction. That is, the second position adjustment unit 222 may serve as a component for increasing or decreasing a horizontal distance between the transport main body 210 and the solar cell C.

The second position adjustment unit 222 according to the present embodiment may be movably connected to a transport rail R disposed parallel to the third direction. The second position adjustment unit 222 may reciprocate along the transport rail R in a direction parallel to the third direction by a driving force generated from a motor, cylinder, or the like. Accordingly, the second position adjustment unit 222 may reciprocate the transport main body 210 between the wire-jig table T and the stage S. A specific shape of the second position adjustment unit 222 is not limited to the shape illustrated in FIGS. 3 to 5 and various design changes are possible within the technical concept of the shape which can be connected to the first position adjustment unit 221 to move the transport main body 210 in a direction different from the first direction.

The transport main body 210 may be connected to the position adjustment unit 220 to be movable in a direction parallel to the longitudinal direction of the wire W. That is, the transport main body 210 may be connected to the first position adjustment unit 221 to reciprocate in a direction parallel to the second direction. The transport main body 210 may receive a driving force generated from a motor, cylinder, or the like and reciprocate in the direction parallel to the second direction.

Although an example in which the transport main body 210 is connected to the first position adjustment unit 221 to be movable in the direction parallel to the second direction and the second position adjustment unit 222 moves in the direction parallel to the third direction has been described above, the present disclosure is not limited thereto, and the transport main body 210 may be fixed to the first position adjustment unit 221, and the second position adjustment unit 222 may simultaneously move in directions parallel to the second and third directions.

The transport main body 210 may be provided as a plurality of transport main bodies. The plurality of transport main bodies 210 may be arranged at set intervals in the second direction on the position adjustment unit 220, more specifically, the first position adjustment unit 221. The number of transport main bodies 210 may correspond to the number of stages S. Accordingly, when the first position adjustment unit 221 moves to a position above the stage S, the plurality of transport main bodies 210 may be disposed to face each stage S independently.

Each transport main body 210 may move independently in the direction parallel to the second direction. Accordingly, the distance between the neighboring transport main bodies 210 may be freely adjusted in response to the length of the wire W, the size of the jig J, and the like.

The transport unit 230 may move along with the transport main body 210 and transport the wire W and the jig J.

The transport unit 230 may be provided as a plurality of transport units. Each transport unit 230 may be separately connected to a different transport main body 210. The plurality of transport units 230 may be arranged in the longitudinal direction of the wire W, that is, the direction parallel to the second direction. Each transport unit 230 may transport the plurality of wires W and jigs J disposed in the second direction on the wire-jig table T onto the first surface C1 of a different solar cell C.

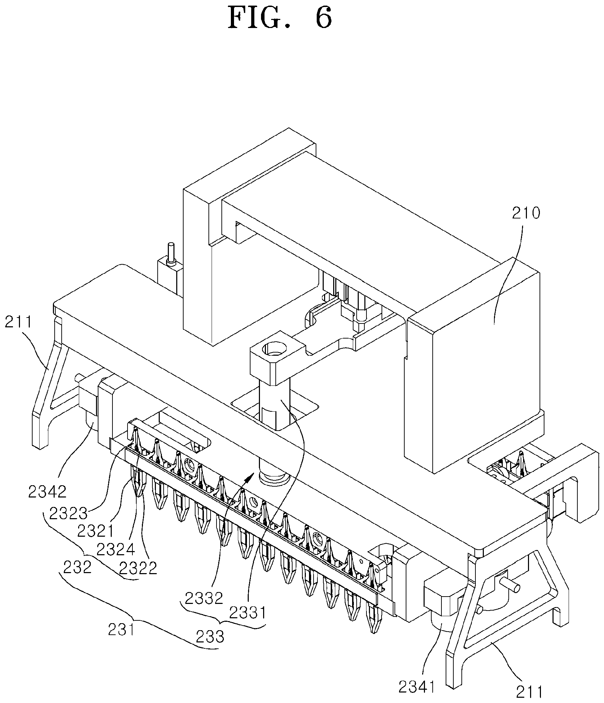

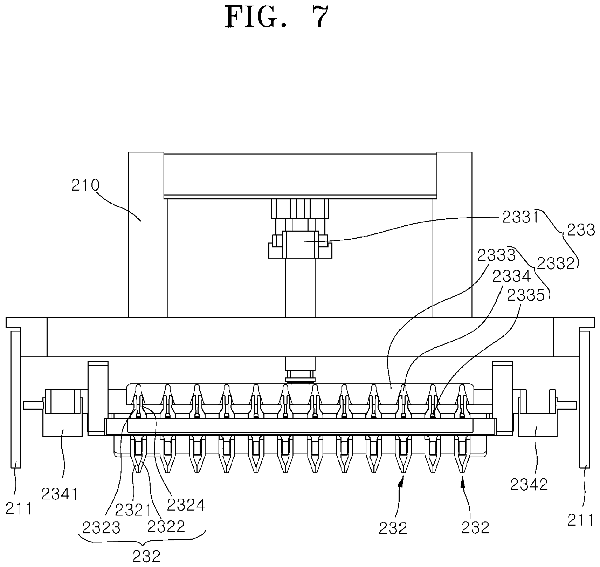

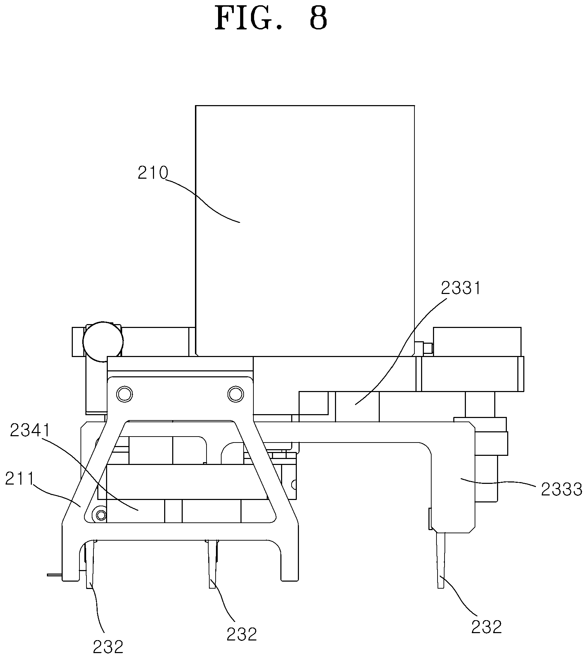

FIG. 6 is a schematic perspective view illustrating a configuration of a transport unit according to one embodiment of the present disclosure, FIG. 7 is a schematic front view illustrating the configuration of the transport unit according to one embodiment of the present disclosure, and FIG. 8 is a schematic side view illustrating the configuration of the transport unit according to one embodiment of the present disclosure.

Referring to FIGS. 1 to 8, the transport unit 230 according to the present embodiment may include a first transport member 231 and a second transport member 234.

The first transport member 231 may form an exterior of one side of the transport unit 230 and transport the wire W.

The first transport member 231 may include a gripper 232 and a gripper driving unit 233.

The gripper 232 may be connected to the transport main body 210 and may grip the wire W by a mechanical force.

For one transport main body 210, a plurality of grippers 232 may be provided.

The plurality of grippers 232 may be arranged in the longitudinal direction of the wire W, that is, the direction parallel to the second direction. For example, for one transport main body 210, the grippers 232 may be arranged in three rows in the second direction. The plurality of grippers 232 arranged in the second direction may individually grip different parts of the wire W, which are spaced apart from each other in the longitudinal direction of the wire W. Accordingly, the gripper 232 can prevent the wire W from being bent or sagging due to gravity or the like when the wire W is transported. Distances between neighboring grippers 232 in the second direction may be the same or may be formed differently.

The plurality of grippers 232 may be arranged in a direction intersecting the longitudinal direction of the wire W. For example, for one transport main body 210, the plurality of grippers 232 may be arranged in the direction parallel to the third direction. Accordingly, the gripper 232 may simultaneously transport a plurality of wires disposed parallel to each other in the third direction to a position above the wire-jig table.

As the transport main body 210 moves to a position above the wire-jig table T, the gripper 232 may be disposed to face the through hole H formed in the jig J. As the transport main body 210 moves toward the wire W on the wire-jig table T, the gripper 232 may be inserted into the through hole H and may protrude outward from the jig J. Accordingly, the gripper 232 may smoothly grip the wire W disposed under the jig J without interference with the jig J on the wire-jig table T.

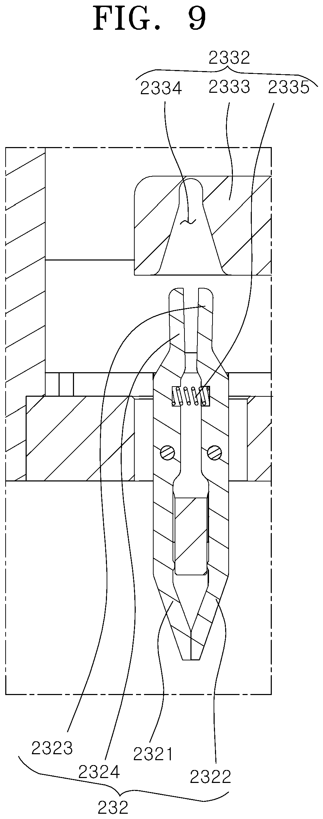

FIG. 9 is a schematic view illustrating a configuration of a gripper according to one embodiment of the present disclosure.

Referring to FIGS. 1 to 9, the gripper 232 may include a first gripper 2321, a second gripper 2322, a first extension 2323, and a second extension 2324.

The first gripper 2321 may be rotatably connected to the transport main body 210. The first gripper 2321 according to the present embodiment may substantially a rod shape. A central portion of the first gripper 2321 may be rotatably connected to the transport main body 210 via a pin, a hinge, or the like. For example, the central portion of the first gripper 2321 may be connected to the transport main body 210 so as to be rotatable around the longitudinal direction of the wire W, that is, the direction parallel to the second direction. An end portion of the first gripper 2321 may protrude outward from the transport main body 210. When the transport main body 210 moves to a position above the wire-jig table T, the end portion of the first gripper 2321 may be disposed to face the wire W in the first direction.

The second gripper 2322 may be spaced apart from the first gripper 2321 and rotatably connected to the transport main body 210.

The second gripper 2322 according to the present embodiment may be disposed to face the first gripper 2321 in a width direction of the wire W, that is, the third direction. The second gripper 2322 may have substantially a rod shape. A central portion of the second gripper 2322 may be rotatably connected to the transport main body 210 via a pin, a hinge, or the like. For example, the central portion of the second gripper 2322 may be connected to the transport main body 210 so as to be rotatable around the longitudinal direction of the wire W, that is, the direction parallel to the second direction. An end portion of the second gripper 2322 may protrude outward from the transport main body 210. When the transport main body 210 moves to a position above the wire-jig table T, the end portion of the second gripper 2322 may be disposed to face the wire W in the first direction.

The first gripper 2321 and the second gripper 2322 may rotate in opposite directions to grip the wire W or release the gripping of the wire W. For example, when the first gripper 2321 rotates counterclockwise and the second gripper 2322 rotates clockwise based on FIG. 9, the distance between the end portions of the first gripper 2321 and the second gripper 2322 may be decreased, and the first gripper 2321 and the second gripper 2322 may grip the wire W by pressing both sides of the wire W.

Conversely, when the first gripper 2321 rotates clockwise and the second gripper 2322 rotates counterclockwise based on FIG. 9, the distance between the end portions of the first gripper 2321 and the second gripper 2322 may be increased, and the first gripper 2321 and the second gripper 2322 may be spaced apart from the wire W and release the gripping of the wire W.

The first extension 2323 and the second extension 2324 may extend from the first gripper 2321 and the second gripper 2322, respectively.

The first extension 2323 and the second extension 2324 according to the present embodiment may have a rod shape extending from the central portions of the first gripper 2321 and the second gripper 2322 in a direction away from the end portions of the first gripper 2321 and the second gripper 2322. The first extension 2323 and the second extension 2324 may be disposed to face each other in the third direction.

The first extension 2323 and the second extension 2324 may rotate in opposite directions to adjust the distance between the first gripper 2321 and the second gripper 2322. The rotational directions of the first extension 2323 and the second extension 2324 may be the same as the rotational directions of the first gripper 2321 and the second gripper 2322, respectively. The distance between the first gripper 2321 and the second gripper 2322 may increase or decrease in inverse proportion to a change in distance between the first extension 2323 and the second extension 2324.

For example, when the first extension 2323 is rotated counterclockwise and the second extension 2324 is rotated clockwise based on FIG. 9, the distance between end portions of the first extension 2323 and the second extension 2324 may increase, and the distance between the end portions of the first gripper 2321 and the second gripper 2322 may decrease.

Conversely, when the first extension 2323 is rotated clockwise and the second extension 2324 is rotated counterclockwise based on FIG. 9, the distance between the end portions of the first extension 2323 and the second extension 2324 may decrease, and the distance between the end portions of the first gripper 2321 and the second gripper 2322 may increase.

The gripper driving unit 233 may be connected to the gripper 232 and may control the gripping operation of the gripper 232. That is, the gripper driving unit 233 may serve as a component for automatically adjusting the distance between the end portions of the first gripper 2321 and the second gripper 2322 by rotating the first extension 2323 and the second extension 2324 by its own driving force.

The gripper driving unit 233 may include an actuator 2331 and an adjustment member 2332.

The actuator 2331 may generate a driving force for operating the adjustment member 2332 to be described below. The actuator 2331 according to the present embodiment may be, for example, various types of power devices for generating a driving force by externally applied power or hydraulic pressure, such as a motor, a hydraulic cylinder, and the like. The actuator 2331 may be fixed to the transport main body 210 by various types of coupling methods, such as welding, bolting, and the like.

The adjustment member 2332 may rotate the first extension 2323 and the second extension 2324 in opposite directions in conjunction with the driving force generated by the actuator 2331.

The adjustment member 2332 may include an adjustment block 2333, an adjustment groove 2334, and a restoring member 2335.

The adjustment block 2333 may be movably installed on the transport main body 210. The adjustment block 2333 may be connected to the actuator 2331 and moved by receiving the driving force from the actuator 2331.

The adjustment block 2333 according to the present embodiment may be disposed to face the end portions of the first extension 2323 and the second extension 2324 in the first direction. The adjustment block 2333 may be installed on the transport main body 210 to reciprocate in the direction parallel to the first direction.

The adjustment block 2333 may be provided as a plurality of adjustment blocks. The plurality of adjustment blocks 2333 installed on one transport main body 210 may be arranged in the second direction. Each adjustment block 2333 may be individually disposed to face a different gripper 232 arranged in the second direction.

The adjustment groove 2334 may be disposed inside the adjustment block 2333. The adjustment groove 2334 may serve as a component for decreasing the distance between the first extension 2323 and the second extension 2324 by the linear movement of the adjustment block 2333.

The adjustment groove 2334 according to the present embodiment may have a groove shape which is concavely recessed from one surface of the adjustment block 2333, which faces the end portions of the first extension 2323 and the second extension 2324, inward of the adjustment block 2333. The adjustment groove 2334 may be disposed to have a longitudinal direction parallel to the first direction.

As the adjustment block 2333 moves in the first direction, the end portions of the first extension 2323 and the second extension 2324 may be inserted into the adjustment groove 2334.

The width of the adjustment groove 2334 may increase from the adjustment block 2333 toward the gripper 232. That is, the width of the adjustment groove 2334 may increase in the first direction. Here, the width of the adjustment groove 2334 may be a width parallel to the third direction.

The width of one end portion of the adjustment groove 2334 located at a surface of the adjustment block 2333 may be sized so that the end portions of the first extension 2323 and the second extension 2324, which are spaced apart from each other, may both be smoothly inserted when the adjustment block 2333 moves downward.

The width of the other end portion of the adjustment groove 2334 located inside the adjustment block 2333 may be sized so that the end portions of the first extension 2323 and the second extension 2324 may come into contact with each other.

Accordingly, when the adjustment block 2333 moves in the first direction, the distance between the first extension 2323 and the second extension 2324 is gradually decreased as the first extension 2323 and the second extension 2324 come into contact with an inner surface of the adjustment groove 2334, and the first extension 2323 and the second extension 2324 may increase the distance between the first gripper 2321 and the second gripper 2322.

As the adjustment block 2333 moves in a direction opposite to the first direction, the end portions of the first extension 2323 and the second extension 2324 may be separated from the inside of the adjustment groove 2334.

The adjustment groove 2334 may be provided as a plurality of adjustment grooves. The plurality of adjustment grooves 2334 may be individually formed in different adjustment blocks 2333. The plurality of adjustment grooves 2334 formed in one adjustment block 2333 may be arranged in the third direction. Each adjustment groove 2334 may be individually disposed to face the first extension 2323 and the second extension 2324 of a different gripper 232.

The restoring member 2335 may serve as a component for increasing the distance between the first extension 2323 and the second extension 2324 by the linear movement of the adjustment block 2333.

The restoring member 2335 according to the present embodiment may be disposed between the first extension 2323 and the second extension 2324. The restoring member 2335 may have both end portions connected to inner surfaces of the first extension 2323 and the second extension 2324, respectively. The restoring member 2335 may be disposed to have a longitudinal direction parallel to the third direction. The restoring member 2335 may be provided to be elastically deformable.

For example, the restoring member 2335 may have the shape of a coil spring which can be compressed or stretched in the longitudinal direction. The restoring member 2335 may apply an elastic force to the first extension 2323 and the second extension 2324 in a direction which separates the first extension 2323 from the second extension 2324. Accordingly, when the adjustment block 2333 moves in the direction opposite to the first direction, the distance between the first extension 2323 and the second extension 2324 is gradually increased by the elastic force of the restoring member 2335 and the contact with the inner surface of the adjustment groove 2334, and the first extension 2323 and the second extension 2324 may decrease the distance between the first gripper 2321 and the second gripper 2322.

The second transport member 234 may form an exterior of the other side of the transport unit 230 and transport the jig J.

The second transport member 234 may include a first jig holder 2341 and a second jig holder 2342 which are connected to the transport main body 210.

The first jig holder 2341 and the second jig holder 2342 according to the present embodiment may transport the jig J by generating an electromagnetic force to adsorb the jig J or release the jig J.

The first jig holder 2341 and the second jig holder 2342 may be disposed to be spaced apart from each other and may individually adsorb different parts of the jig J.

The first jig holder 2341 and the second jig holder 2342 may be disposed to be spaced apart from each other with the first transport member 231 interposed therebetween. The first jig holder 2341 and the second jig holder 2342 may be disposed at both sides of the first transport member 231, respectively. The first jig holder 2341 and the second jig holder 2342 may be spaced apart from each other in a direction intersecting the longitudinal direction of the wire W. For example, the first jig holder 2341 and the second jig holder 2342 may be spaced apart from each other in the third direction with the gripper 232 interposed therebetween. Accordingly, the first jig holder 2341 and the second jig holder 2342 may smoothly adsorb the jig J without interference with the gripper 232.

The first jig holder 2341 and the second jig holder 2342 may protrude from the transport main body 210 in the first direction. The lengths by which the first jig holder 2341 and the second jig holder 2342 protrude from the transport main body 210 may be smaller than the length by which the gripper 232 protrudes from the transport main body 210. That is, an end of the gripper 232 adjacent to the wire W may be located below the bottom surfaces of the first jig holder 2341 and the second jig holder 2342. Accordingly, after the first jig holder 2341 and the second jig holder 2342 come into contact with the jig J, the gripper 232 may protrude outward from the jig J through the through hole H. Accordingly, the first transport member 231 and the second transport member 234 may simultaneously transport the jig J disposed on the wire W.

Hereinafter, an operation process of a transport device according to one embodiment of the present disclosure will be described.

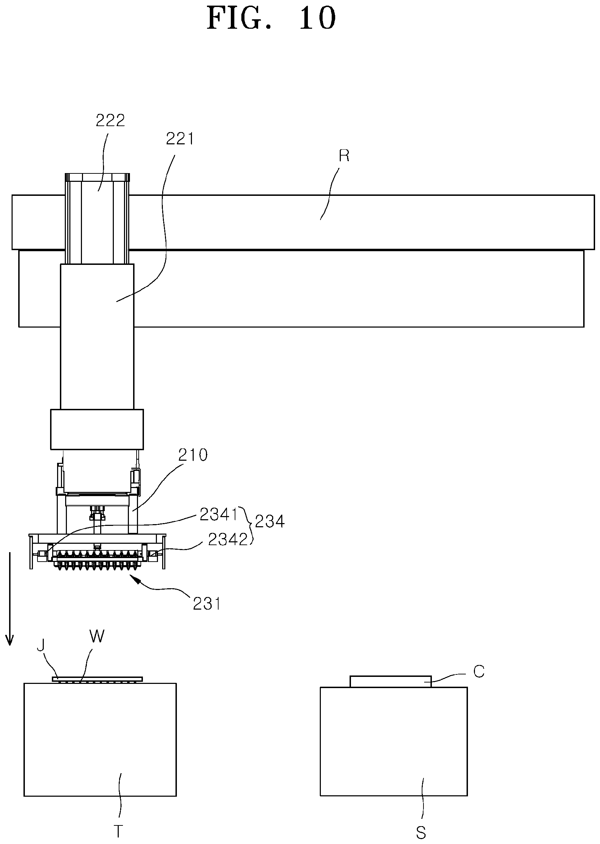

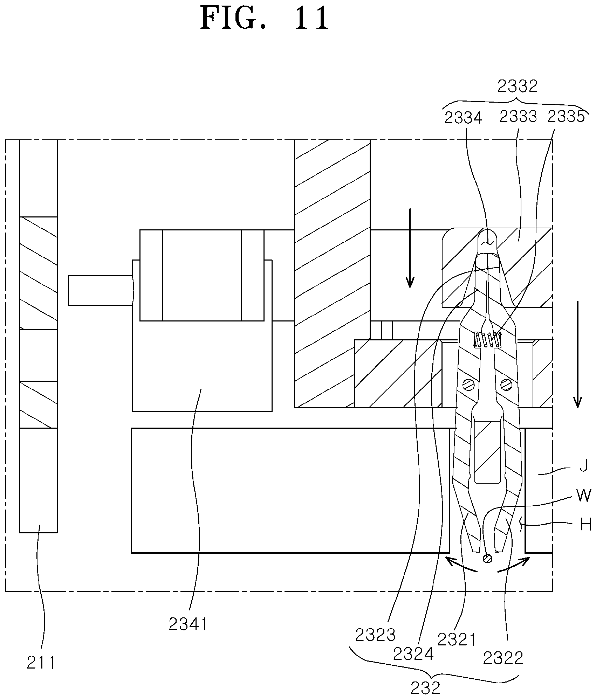

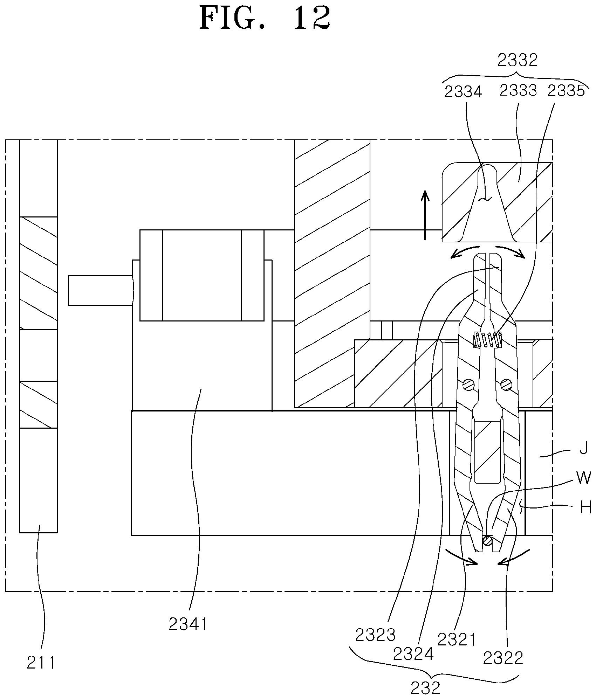

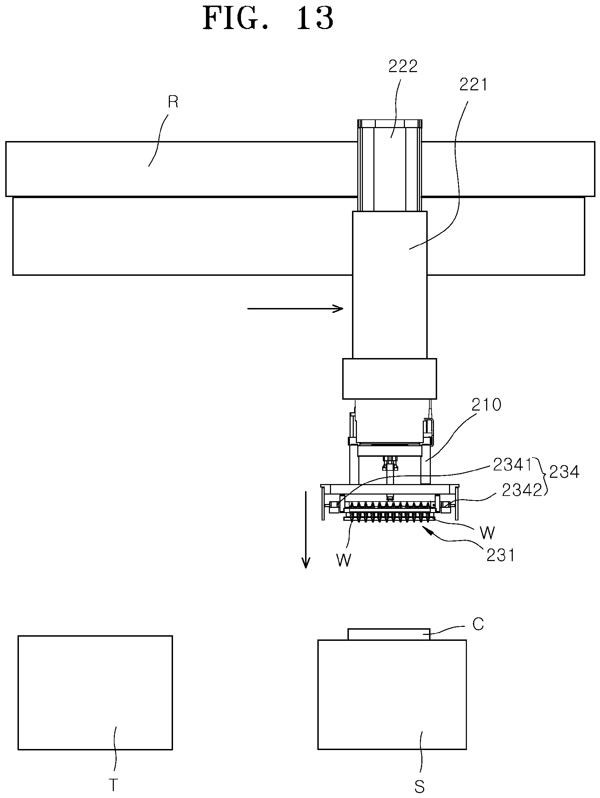

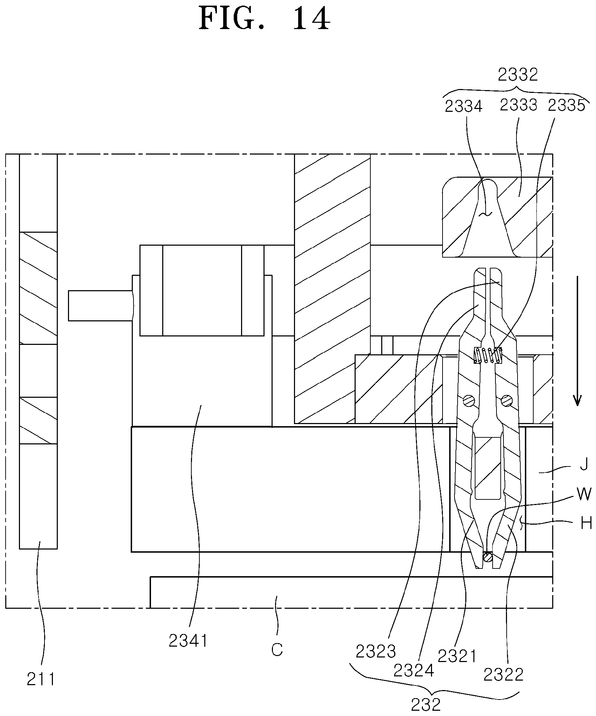

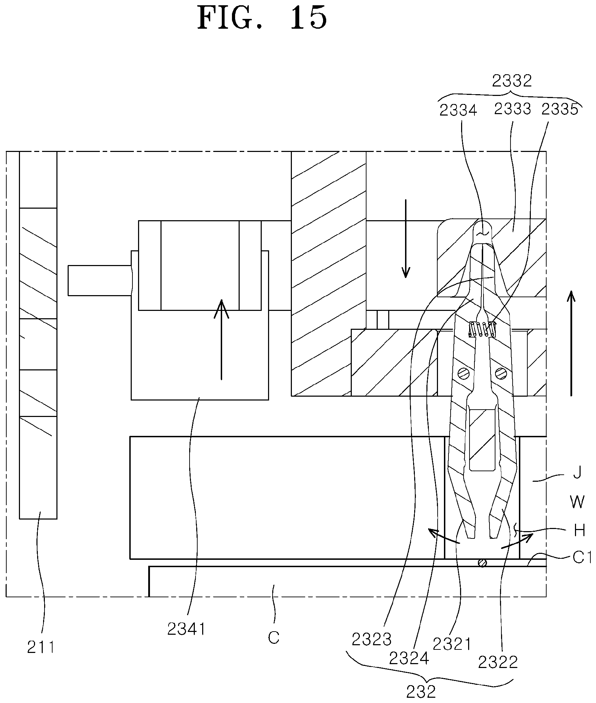

FIGS. 10 to 15 are schematic views illustrating an operation process of the transport device according to one embodiment of the present disclosure.

Referring to FIGS. 10 to 15, the solar cell C is transported onto the stage S, and in a state in which the wire W and the jig J are stacked on the wire-jig table T, the transport main body 210 moves to a position above the wire-jig table T.

Thereafter, the transport main body 210 moves in the first direction, and the first jig holder 2341 and the second jig holder 2342 come into contact with the jig J.

The first jig holder 2341 and the second jig holder 2342 generate an electromagnetic force by externally applied power and adsorb the jig J.

As the transport main body 210 moves in the first direction, the end portions of the first gripper 2321 and the second gripper 2322 are inserted into the through hole H and protrude outward from the jig J.

During this process, the adjustment block 2333 moves in the first direction, and the end portions of the first extension 2323 and the second extension 2324 are inserted into the adjustment groove 2334.

The distance between the first extension 2323 and the second extension 2324 is gradually decreased as the first extension 2323 and the second extension 2324 come into contact with the inner surface of the adjustment groove 2334, and the distance between the first gripper 2321 and the second gripper 2322 increases.

Thereafter, as the support frame 211 is in contact with the wire-jig table T, the first gripper 2321 and the second gripper 2322 may be disposed to face both sides of the wire W at a predetermined distance, respectively.

The adjustment block 2333 moves in the direction opposite to the first direction, and the end portions of the first extension 2323 and the second extension 2324 are separated from the adjustment groove 2334.

The distance between the first extension 2323 and the second extension 2324 is gradually increased by the elastic force of the restoring member 2335.

Accordingly, the distance between the first gripper 2321 and the second gripper 2322 decreases, and the first gripper 2321 and the second gripper 2322 may press both surfaces of the wire W and grip the wire W.

The transport main body 210 moves to a position facing the stage S on which the solar cell C is seated in the first direction.

As the transport main body 210 moves in the first direction, the support frame 211 comes into contact with the stage S, and the wire W is seated on the first surface C1 of the solar cell C.

After the wire W is seated on the solar cell C, the adjustment block 2333 moves in the first direction, and the first gripper 2321 and the second gripper 2322 release the gripping state of the wire W.

The power applied to the first jig holder 2341 and the second jig holder 2342 is cut off, and the first jig holder 2341 and the second jig holder 2342 release the adsorption state of the jig J.

Thereafter, the transport main body 210 moves in the direction opposite to the first direction, and the transport device 20 repeatedly performs the above operation on a different solar cell C.

The bonding device 40 may bond the solar cell C and the wire W. After the operation of the transport device, the bonding device 40 may receive the solar cell C, the wire W, and the jig J from the stage S.

For example, the bonding device 40 may include a conveyor for continuously transporting the solar cell C, the wire W, and the jig J which are received from the stage 310, and a heating device for melting a solder layer of the wires W moved by the conveyor or heating an ECA applied to the connecting portion of the solar cell C and the wire W.

According to the present disclosure, since a transport device simultaneously moves a wire and a jig onto a solar cell, the overall process time can be shortened and the size of equipment can be reduced compared to a case in which the wire and the jig are transported by separate devices.

According to the present disclosure, since the position of a transport unit device can be freely changed in three dimensions by the movement of a position adjustment unit and a transport main body, the wire and the jig can be efficiently transported.

According to the present disclosure, since the distance between the plurality of transport units can be freely adjusted, flexible application to solar cell modules of various specifications is possible.

Although the present disclosure has been described with reference to embodiments illustrated in the drawings, the embodiments are merely illustrative, and those skilled in the art will understand that various modifications and equivalent other embodiments are possible therefrom.
Accordingly, the technical scope of the present disclosure should be determined by the appended claims.

## Claims

1. A transport device comprising:
a transport main body;
a position adjustment unit configured to support the transport main body and adjust a position of the transport main body; and
a transport unit configured to move along with the transport main body and transport a wire and a jig.

2. The transport device of claim 1, wherein the position adjustment unit includes:
a first position adjustment unit connected to the transport main body and configured to move the transport main body in a direction parallel to a first direction; and
a second position adjustment unit connected to the first position adjustment unit and configured to move the transport main body in a direction intersecting the first direction.

3. The transport device of claim 1, wherein the transport main body is connected to the position adjustment unit to be movable in a direction parallel to a longitudinal direction of the wire.

4. The transport device of claim 1, wherein the transport unit includes:
a first transport member connected to the transport main body and configured to transport the wire; and
a second transport member spaced apart from the first transport member and configured to transport the jig.

5. The transport device of claim 4, wherein the first transport member includes:
a gripper connected to the transport main body and configured to grip the wire; and
a gripper driving unit connected to the gripper and configured to adjust a gripping operation of the gripper.

6. The transport device of claim 5, wherein the jig includes a through hole, and
as the transport main body moves toward the wire, the gripper is inserted into the through hole and protrudes outward from the jig.

7. The transport device of claim 5, wherein the gripper is provided as a plurality of grippers, and the plurality of grippers are arranged in a longitudinal direction of the wire.

8. The transport device of claim 5, wherein the gripper includes:
a first gripper rotatably connected to the transport main body;
a second gripper disposed to face the first gripper and rotatably connected to the transport main body;
a first extension extending from the first gripper; and
a second extension extending from the second gripper and disposed to face the first extension, and
the first extension and the second extension rotate in opposite directions and adjust a distance between the first gripper and the second gripper.

9. The transport device of claim 8, wherein the gripper driving unit includes:
an actuator configured to generate a driving force; and
an adjustment member configured to rotate the first extension and the second extension in opposite directions in conjunction with the driving force generated by the actuator.

10. The transport device of claim 9, wherein the adjustment member includes:
an adjustment block which is installed to be movable on the transport main body and receives the driving force from the actuator to move;
an adjustment groove which is disposed inside the adjustment block and into which the first extension and the second extension are inserted; and
a restoring member disposed between the first extension and the second extension.

11. The transport device of claim 10, wherein a width of the adjustment groove increases from the adjustment block toward the gripper.

12. The transport device of claim 10, wherein the restoring member is provided to be elastically deformable.

13. The transport device of claim 4, wherein the second transport member includes:
a first jig holder disposed to face one side of the first transport member; and
a second jig holder spaced apart from the first jig holder and disposed to face the other side of the first transport member.

14. The transport device of claim 13, wherein the first jig holder and the second jig holder generate an electromagnetic force to adsorb the jig.

15. A tabbing apparatus comprising:
a supply device configured to supply a solar cell, a wire, and a jig;
a transport device configured to seat the wire and the jig on the solar cell; and
a bonding device configured to bond the solar cell and the wire,
wherein the transport device includes:
a transport main body;
a position adjustment unit configured to support the transport main body and adjust a position of the transport main body; and
a transport unit configured to move along with the transport main body and transport the wire and the jig.
